Europäisches Patentamt

(19) European Patent Office

Office européen des brevets

(11) Publication number: **0 136 229 B1**

# EUROPEAN PATENT SPECIFICATION

(45) Date of publication of patent specification: 05.06.91  (51) Int. Cl.⁵ **G11C 7/06**

(21) Application number: 84401825.9

(22) Date of filing: 14.09.84

(54) Sense amplifier.

(30) Priority: 17.09.83 JP 171683/83

(43) Date of publication of application:
03.04.85 Bulletin 85/14

(45) Publication of the grant of the patent:
05.06.91 Bulletin 91/23

(84) Designated Contracting States:
DE FR GB

(56) References cited:
US-A- 3 953 839

PATENT ABSTRACTS OF JAPAN, vol. 5, no.
84 (P-64)[756], 2nd June 1981; & JP-A-56 29
889 (SUWA SEIKOSHA K.K.) 25-03-1981

PATENT ABSTRACTS OF JAPAN, vol. 5, no.
64 (P-59)[736], 30th April 1981; & JP-A-56 16
992 (HITACHI SEISAKUSHO K.K.) 18-02-1981

PATENT ABSTRACTS OF JAPAN, vol. 3, no.
26 (E-95), 6th March 1979, page 9 E95; &
JP-A-54 4029 (NIPPON DENKI K.K.) 12-01-1979

IBM TECHNICAL DISCLOSURE BULLETIN, vol.
24, no. 11A, April 1982, pages 5654-5656, New
York, US; Y.H. CHAN: "Bit-select sense am-

plifier"

(73) Proprietor: **FUJITSU LIMITED**
1015, Kamikodanaka Nakahara-ku
Kawasaki-shi Kanagawa 211(JP)

(72) Inventor: **Koshizuka, Atuo**
Seiwa-so 5 395, Shimokadanaka Nakahara-ku
Kawasaki-shi Kanagawa 211(JP)

(74) Representative: **Descourtieux, Philippe et al**
**CABINET BEAU de LOMENIE** 55 rue
d'Amsterdam
F-75008 Paris(FR)

**Description**

(1) Field of the Invention

The present invention relates to a sense amplifier used, for example, in a static-type semiconductor memory device, one of the functions of the sense amplifier being to select one of a plurality of input signals.

(2) Description of the Prior Art

In a static-type RAM device, a very small voltage difference of, for example, about 0.5 V, output from a memory cell and transmitted to a pair of data buses is amplified by a sense amplifier when readout operation is effected.

However, in a conventional static-type RAM device, especially a large capacity RAM device, since a bit line pair, column transfer gates, and a data bus pair are connected to a selected memory cell, the load of the memory cell becomes heavy, and the readout speed is deteriorated. Especially, in a large capacity RAM device, each bit line and data bus become long and thin, and the on-resistance of the column transfer gates becomes large. Therefore, if the drive ability of each memory cell is not large, it takes a long time for the input signal of the sense amplifier to reach a steady state signal level.

Various solutions to this problem have been put forward. For instance the use of a sense latch to detect small differential signals on the memory bit lines has been proposed (US 3 953 839). One latch circuit is required for each pair of bit/sense lines, plus a final latch providing a driver output.

Another known solution (JP-A-56 29 889) proposes a MOS circuit for mutually inverting the potential of a readout bus line of a sense circuit corresponding to two respective sets of digit lines. This solution utilizes two sense amplifiers per memory cell, each amplifier receiving a mutually inverted digit line.

Yet another solution (IBM TECHNICAL DISCLOSURE BULLETIN, Vol. 24, N° 11A, April 1982 pages 5654-5656) proposes a bit line sense amplifier, operating in current mode switching, for each word group. The sense amplifiers' input stages are controlled by sensing transistors configured as a big-current switch, with their buses connected to bit rails of the word group.

SUMMARY OF THE INVENTION

It is an object of the present invention to decrease the load of each selected memory cell and to speed up the operation of a semiconductor memory device.

According to the present invention, there is provided a sense amplifier of a differential amplifier type for receiving pairs of complementary input signals and generating an output signal corresponding to a selected pair of complementary input signals in accordance with received address signals applied thereto, having: a pair of input circuit portions, one of said input circuit portions comprising a plurality of circuit units each generating the amplified output of one of a pair of complementary input signals in response to one of said address signals applied thereto, and the other input circuit portion comprising a plurality of circuit units each generating the amplified output of the other one of said pair of complementary input signals in response to said one of said address signals, each of said circuit units comprising a serial connection of a pair of MIS transistors, one of which receives a decoded address signal at a gate thereof, and the other one of which receives one of said complementary input signals at the gate thereof, each of said input circuit portions being constituted by a parallel connection of a plurality of said serial connections of MIS transistors; load circuits each comprising a MIS transistor respectively connected in series between said parallel connections forming the respective input circuit portions and a power supply terminal; characterized in that the sense amplifier further comprises a constant current circuit comprised of a MIS transistor connected between a common terminal and a terminal of a power source; said MIS transistors that receive a decoded address signal have their sources connected to said common terminal; one of said load circuits has a direct gate-drain connection, and the gates of the load MIS transistors and the gate of the MIS transistor of said constant current circuit being commonly connected.

BRIEF DESCRIPTION OF THE DRAWINGS

Figure 1 is a block circuit diagram illustrating a conventional static-type RAM device;
Figure 2 is a schematic circuit diagram illustrating a circuit structure of each memory block used in the RAM device of Fig. 1; and
Figure 3 is a circuit diagram illustrating a sense amplifier as an embodiment of the present invention.

DESCRIPTION OF THE PREFERRED EMBODIMENT

Before describing the preferred embodiment, an explanation will be given of a static-type RAM device using conventional sense amplifiers with reference to the drawings.

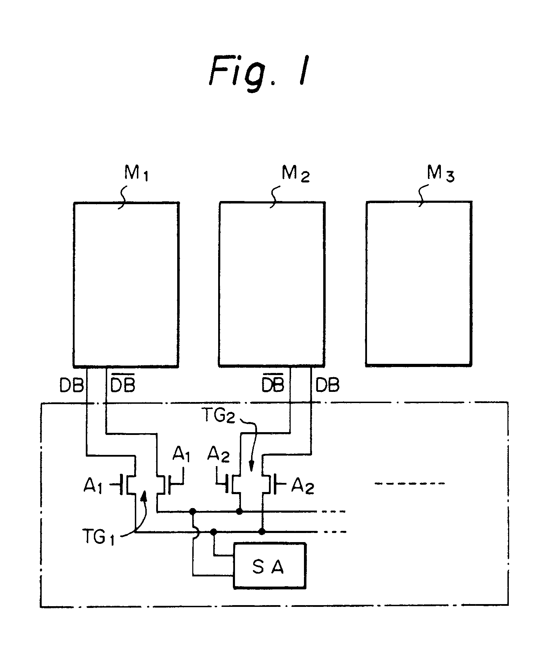

Figure 1 illustrates a general static-type RAM device in which one sense amplifier SA is provided for one memory chip, and memory cells therein are divided into a plurality of memory blocks $M_1$, $M_2$, ---. In the memory device of Fig. 1, data bus pairs DB and $\overline{DB}$ (where $\overline{DB}$ is an inversion of DB) of each memory block $M_1$, $M_2$, --- are coupled together to a common sense amplifier SA via transfer gates $TG_1$, $TG_2$, ---, respectively. Therefore, it is possible to selectively connect the data bus pair DB and $\overline{DB}$ of each of the memory blocks $M_1$, $M_2$, --- to the sense amplifier SA by using address signals $A_1$, $A_2$, --- which are added to the transfer gates $TG_1$, $TG_2$, ---. Each of the memory blocks $M_1$, $M_2$, --- comprises a matrix arrangement of a plurality of memory cells disposed at the intersections of word lines and bit lines, and it is necessary to increase the number of the memory blocks when a high operation speed and low power consumption are necessitated.

There is also known a memory device which comprises a sense amplifier for every data bus pair DB and $\overline{DB}$, i.e., for every memory block $M_i$, in which one of the output signals of the sense amplifiers is selected by using a selection logic circuit provided in the output portion of the sense amplifiers.

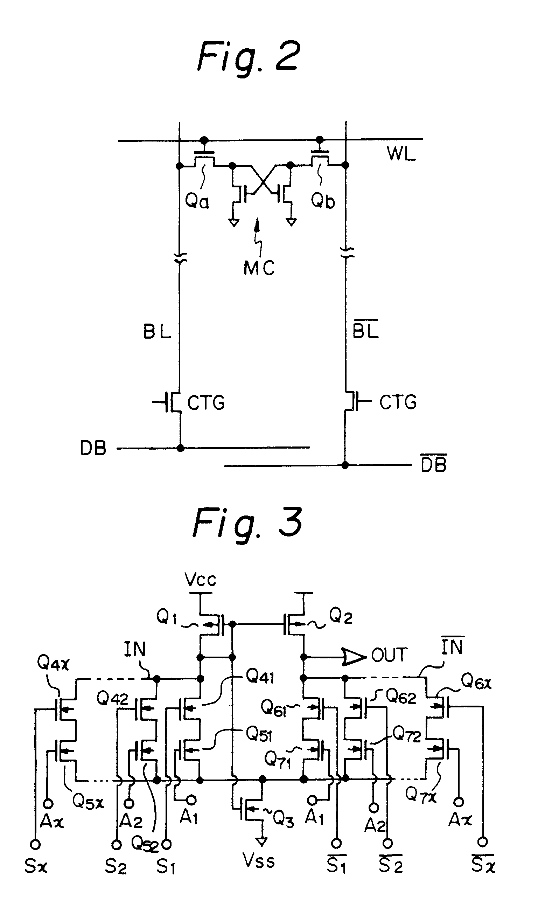

In the cases mentioned above, as illustrated in Fig. 2, the loads of a selected memory cell MC are a bit line pair BL and $\overline{BL}$, and the data bus pair DB and $\overline{DB}$ which is connected to the bit line pair BL and $\overline{BL}$ via column transfer gates CTG, and the aforementioned transfer gates $TG_i$ in the case of the memory device of Fig. 1. Therefore, it takes a long time for the input signal of the sense amplifier to reach a steady state signal level if the drive ability of each memory cell MC, i.e., gm of the transistors constituting the memory cell MC, is small. Especially, since each of the column transfer gates CTG and the transfer gates TG is not completely turned on even in a selected condition and has some resistance, the RC time constant of each transfer gate circuit becomes relatively large and the signal passing through the transfer gate circuit is delayed. In Fig. 2, WL designates a word line, and the input/output terminals of the memory cell MC composed of a flip-flop are connected to the bit lines BL and $\overline{BL}$ via transfer gate transistors $Q_a$ and $Q_b$, whose gate electrodes are connected to the word line WL. These transistors $Q_a$ and $Q_b$ also become the load of the memory cell MC.

As mentioned above, the device shown in Figs. 1 and 2 has the disadvantages of a heavy load for each memory cell and a low operation speed.

According to the present invention, there is provided a sense amplifier which overcomes these problems, as described below.

Figure 3 is a circuit diagram illustrating a CMOS type sense amplifier as an embodiment of the present invention. The sense amplifier comprises a pair of complementary input terminals IN and $\overline{IN}$, P-channel MOS transistors $Q_1$ and $Q_2$ operating as loads, an N-channel MOS transistor $Q_3$ operating as a constant current source, and an output terminal OUT. The sense amplifier of Fig. 3 further comprises x sets of series connections of N-channel MOS transistors $Q_{41}$ and $Q_{51}$; $Q_{42}$ and $Q_{52}$; ---; $Q_{4x}$ and $Q_{5x}$, which are mutually connected in parallel between the input terminal IN and the drain of the transistor $Q_3$, and x sets of series connections of N-channel MOS transistors $Q_{61}$ and $Q_{71}$; $Q_{62}$ and $Q_{72}$; ---; $Q_{6x}$ and $Q_{7x}$, which are mutually connected in parallel between the input terminal $\overline{IN}$ and the drain of the transistor $Q_3$. The transistors $Q_{51}$ and $Q_{71}$, $Q_{52}$ and $Q_{72}$, ---, $Q_{5x}$ and $Q_{7x}$ are controlled by the outputs $A_1$ through $A_x$ of an address decoder, respectively. The transistors $Q_{41}$, $Q_{42}$, ---, $Q_{4x}$ are controlled by input signals $S_1$, $S_2$, ---, $S_x$, respectively, and the transistors $Q_{61}$, $Q_{62}$, ---, $Q_{6x}$ are controlled by inverted input signals $\overline{S_1}$, $\overline{S_2}$, ---, $\overline{S_x}$, respectively. It should be noted that a conventional CMOS type sense amplifier comprises only the load transistors $Q_1$ and $Q_2$, the transistor $Q_3$, and one pair of driver transistors, such as $Q_{41}$ and $Q_{61}$, connected between the input terminal IN and the drain of the transistor $Q_3$ and between the input terminal $\overline{IN}$ and the drain of the transistor $Q_3$.

Where the sense amplifier of Fig. 3 is adopted to the memory device of Fig. 1, it is used as a substitute for the circuit portion surrounded by dot-dash line of Fig. 1. Therefore, the data buses DB and $\overline{DB}$ of the memory blocks $M_1$, $M_2$, --- are connected to the gates of the transistors $Q_{41}$ and $Q_{61}$; $Q_{42}$ and $Q_{62}$, ---, $Q_{4x}$ and $Q_{6x}$, respectively.

As apparent from Fig. 3, each set of the transistors $Q_{4i}$ and $Q_{5i}$ (i = 1, 2, ---, x) composes an AND gate having two inputs $S_i$ and $A_i$, and each set of the transistors $Q_{6i}$ and $Q_{7i}$ composes an AND gate having two inputs $\overline{S_i}$ and $A_i$. Therefore, when the outputs $A_1$ through $A_x$ of the address decoder are all low, the transistors $Q_{51}$, $Q_{52}$, ---, $Q_{5x}$, and $Q_{71}$, $Q_{72}$, ---, $Q_{7x}$ are all turned off, and the sense amplifier is in a standby status.

When an output $A_i$ of the address decoder corresponding to the inputs $S_i$ and $\overline{S_i}$ becomes high, the potentials of the input terminals IN and $\overline{IN}$ become high and low, respectively, if the inputs $S_i$ and $\overline{S_i}$ are low and high, respectively, and become low and high, respectively, if the inputs $S_i$ and $\overline{S_i}$ are high and low, respectively. The potential of the output terminal OUT is the same as that of the input terminal $\overline{IN}$ and determined by the above relationships of the signals.

Where the sense amplifier is provided for every data bus pair DB and $\overline{DB}$, the inputs $S_1$ and $\overline{S_1}$, $S_2$ and $\overline{S_2}$, ---, $S_x$ and $\overline{S_x}$ are signals from the bit lines in a memory block, and the circuit of Fig. 3 is used as a column sense amplifier. The transistor pairs $Q_{51}$ and $Q_{71}$ , $Q_{52}$ and $Q_{72}$ , --- $Q_{5x}$ and $Q_{7x}$ correspond to column transfer gates CTG. In this case, the load of each memory cell can be greatly decreased because the memory cell does not drive the data buses. It is also possible to combine the outputs of a plurality of column sense amplifiers into one circuit route by further using one stage of a sense amplifier having a similar constitution.

Although the CMOS type circuit was explained above, the present invention can be also adopted to an N-MOS type circuit and the like.

As mentioned above, according to the present invention, since each sense amplifier itself has the function of selecting inputs, the load of each memory cell can be decreased when the sense amplifier is used as a column sense amplifier whose input terminals are connected to bit lines. When the sense amplifier is used as a sense amplifier whose input terminals are connected to data buses, it is possible to increase the readout speed because the transfer gates TG can be omitted. When the sense amplifiers are used in a two level hierarchical structure including a bit line stage and a data bus stage, it is possible to constitute a readout circuit stage having high response speed and simple connection patterns.

## Claims

1. A sense amplifier of a differential amplifier type for receiving pairs of complementary input signals $(S_1, \overline{S}_1; S_2, \overline{S}_2; ...S_x, \overline{S}_x)$ and generating an output signal (OUT) corresponding to a selected pair of complementary input signals in accordance with received address signals $(A_1, A_2, ... A_x)$ applied thereto, having:
   - a pair of input circuit portions, one of said input circuit portions comprising a plurality of circuit units (Q41,Q51; Q42,Q52; .. Q4x, Q5x) each generating the amplified output of one of a pair of complementary input signals in response to one of said address signals $(A_1, A_2, ... A_x)$ applied thereto, and the other input circuit portion comprising a plurality of circuit units (Q61,Q71; Q62,Q72;... Q6x,Q7x) each generating the amplified output of the other one of said pair of complementary input signals in response to said one of said address signals, each of said circuit units (Q41,Q51; Q42,Q52;.... Q4x,Q5x; Q61,Q71; Q62,Q72; ... Q6x,Q7x) comprising a serial connection of a pair of MIS transistors, one of which (Q51,Q52, ... Q5x Q71,Q72,... Q7x) receives a decoded ad-

dress signal $(A_1, A_2, ... A_x)$ at a gate thereof, and the other one (Q41,Q42, ... Q4x; Q61,Q62, ... Q6x) of which receives one of said complementary input signals $(S_1, \overline{S}_1; S_2, \overline{S}_2; S_3, \overline{S}_3;... S_x, \overline{S}_x)$ at the gate thereof, each of said input circuit portions being constituted by a parallel connection of a plurality of said serial connections of MIS transistors;
   - load circuits each comprising a MIS transistor (Q1,Q2) respectively connected in series between said parallel connections forming the respective input circuit portions and a power supply terminal (Vcc); characterized in that the sense amplifier further comprises a constant current circuit comprised of a MIS transistor (Q3) connected between a common terminal and a terminal (Vss) of a power source;
   - said MIS transistors (Q51,Q52...Q5x; Q71,Q72,...Q7x) that receive a decoded address signals $(S_1, \overline{S}_1; S_2, \overline{S}_2; ...S_x, \overline{S}_x)$ have their sources connected to said common terminal;
   - one of said load circuits (Q1) has a direct gate-drain connection, and
   - the gates of the load MIS transistors (Q1, Q2) and the gate of the MIS transistor (Q3) of said constant current circuit being commonly connected.

2. A sense amplifier according to claim 1, characterized in that the said other respective MIS transistors (Q41, Q42, ... Q4x; Q61, Q62, ... Q6x) of each of said circuit units are connected to bit lines of a memory device.

3. A sense amplifier according to claim 1, characterized in that the said other respective MIS transistors (Q41, Q42, ... Q4x; Q61, Q62, ... Q6x) are connected to data buses of a memory device.

## Revendications

1. Amplificateur de lecture du type amplificateur différentiel destiné à recevoir des paires de signaux d'entrée complémentaires $(S_1, \overline{S}_1 ; S_2, \overline{S}_2 ; ... ; S_x, \overline{S}_x)$ et à produire un signal de sortie (OUT) correspondant à une paire sélectionnée de signaux d'entrée complémentaires en fonction de signaux d'adresse reçus $(A_1, A_2,..., A_x)$ qui lui sont appliqués, possédant :
   - une paire de parties de circuit d'entrée, une desdites parties de circuit d'entrée comprenant plusieurs unités de circuit $(Q_{41}, Q_{51} ; Q_{42}, Q_{52} ; ... ; Q_{4x}, Q_{5x})$ produisant chacune le signal de sortie amplifié d'un signal d'une paire de signaux d'entrée complémentaires en réponse à l'un desdits signaux d'adresse ($A_1$, $A_2$,..., $A_x$) qui lui est appliqué, et l'autre partie de circuit d'entrée comprenant plusieurs unités de circuit ($Q_{61}$, $Q_{71}$ ; $Q_{62}$, $Q_{72}$ ; ... ; $Q_{6x}$, $Q_{7x}$) produisant chacune le signal de sortie amplifié de l'autre signal de ladite paire de signaux d'entrée complémentaires en réponse audit signal d'adresse, chacune desdites unités de circuit ($Q_{41}$, $Q_{51}$ ; $Q_{42}$, $Q_{52}$ ; ... ; $Q_{4x}$, $Q_{5x}$ ; $Q_{61}$, $Q_{71}$ ; $Q_{62}$, $Q_{72}$ ; ... ; $Q_{6x}$, $Q_{7x}$) comprenant une connexion série d'une paire de transistors MIS, dont l'un ($Q_{51}$, $Q_{52}$,..., $Q_{5x}$ ; $Q_{71}$, $Q_{72}$,..., $Q_{7x}$) reçoit un signal d'adresse décodé ($A_1$, $A_2$,..., $A_x$) sur sa grille, et l'autre ($Q_{41}$, $Q_{42}$,..., $Q_{4x}$ ; $Q_{61}$, $Q_{62}$,..., $Q_{6x}$) reçoit l'un desdits signaux d'entrée complémentaires ($S_1$, $\overline{S}_1$ ; $S_2$, $\overline{S}_2$ ; $S_3$, $\overline{S}_3$ ; ..., $S_x$, $\overline{S}_x$) sur sa grille, chacune desdites parties de circuit d'entrée étant constituée par une connexion parallèle d'une pluralité desdites connexions série de transistors MIS ;

- des circuits de charge, comprenant chacun un transistor MIS, ($Q_1$, $Q_2$) respectivement connectés en série entre lesdites (connexions parallèle formant les parties de circuit d'entrée respectives et une borne d'alimentation électrique (Vcc) ; caractérisé en ce que l'amplificateur de lecture comprend en outre un circuit à courant constant constitué par un transistor MIS ($Q_3$) connecté entre une borne commune et une borne (Vss) d'une source d'alimentation électrique ;

- lesdits transistors MIS ($Q_{51}$, $Q_{52}$,..., $Q_{5x}$ ; $Q_{71}$, $Q_{72}$,..., $Q_{7x}$) qui reçoivent un signal d'adresse décodé ($S_1$, $\overline{S}_1$ ; $S_2$, $\overline{S}_2$ ; ... ; $S_x$, $\overline{S}_x$) sont connectés par leurs sources à ladite borne commune ;

- un desdits circuits de charge ($Q_1$) possède une connexion grille-drain directe, et

- les grilles des transistors MIS de charge ($Q_1$, $Q_2$) et la grille du transistor MIS ($Q_3$) dudit circuit à courant constant étant connectées en commun.

2. Amplificateur de lecture selon la revendication 1, caractérisé en ce que lesdits autres transistors MIS respectifs ($Q_{41}$, $Q_{42}$,..., $Q_{4x}$ ; $Q_{61}$, $Q_{62}$,..., $Q_{6x}$) de chacune desdites unités de circuit sont connectés à des lignes de bit d'un dispositif de mémorisation.

3. Amplificateur de lecture selon la revendication 1, caractérisé en ce que lesdits autres transis-

tors MIS respectifs ($Q_{41}$, $Q_{42}$,..., $Q_{4x}$ ; $Q_{61}$, $Q_{62}$,..., $Q_{6x}$) sont connectés à des bus de données d'un dispositif de mémorisation

## Ansprüche

1. Leseverstärker vom Typ eines Differenzverstärkers, zum Empfangen von Paaren von komplementären Eingangssignalen ($S_1$, $\overline{S}_1$ ; $S_2$, $\overline{S}_2$ ; ... $S_x$, $\overline{S}_x$) und zum Erzeugen eines Ausgangssignals (OUT), welches einem ausgewählten Paar von komplementären Eingangssignalen entspricht, in Übereinstimmung mit empfangenen Adreßsignalen ($A_1$, $A_2$, ... $A_x$), die ihnen zugeführt werden, mit :

- einem Paar von Eingangsschaltungsabschnitten, von denen ein Eingangsschaltungsabschnitt eine Vielzahl von Schaltungseinheiten (Q41, Q51; Q42, Q52; ...;Q4x, Q5x) umfaßt, die jeweils den verstärkten Ausgang von einem von einem Paar von komplementären Eingangssignalen in Abhängigkeit von einem der genannten Adreßsignale ($A_1$, $A_2$, ... $A_x$), die ihnen zugeführt werden, erzeugen, und der andere Eingangsschaltungsabschnitt eine Vielzahl von schaltungseinheiten (Q61, Q71; Q62, Q72; ... Q6x, Q7x) umfaßt, die jeweils den verstärkten Ausgang von dem anderen von dem genannten Paar von komplementären Eingangssignalen erzeugen, in Abhängigkeit von dem genannten einen der genannten Adreßsignale, wobei jede der genannten Schaltungseinheiten (Q41, Q51; Q42, Q52, ... Q4x, Q5x; Q61, Q71; Q62, Q72; ... Q6x, Q7x) eine Reihenverbindung von einem Paar von MIS-Transistoren umfaßt, von denen einer (Q51, Q52, ... Q5x; Q71, Q72, ... Q7x) ein decodiertes Adreßsignal ($A_1$, $A_2$, ... $A_x$) an seinem einen Gate empfängt, und der andere (Q41, Q42, ... Q4x; Q61, Q62, ... Q6x) eines der genannten komplementären Eingangssignale ($S_1$, $\overline{S}_1$ ; $S_2$, $\overline{S}_2$ ; $S_3$, $\overline{S}_3$ ; ... $S_x$, $\overline{S}_x$) an seinem Gate empfängt, wobei jeder der genannten Eingangsschaltungsabschnitte aus einer Parallelverbindung einer Vielzahl der genannten seriellen Verbindungen von MIS-Transistoren aufgebaut ist;

- Lastschaltungen, die jeweils einen MIS-Transistor (Q1, Q2) umfassen, die jeweils in Reihe zwischen den genannten parallelen Verbindungen, die die entsprechenden Eingangsschaltungsabschnitte bilden, und einem Energieversorgungsanschluß (Vcc) verbunden sind; dadurch gekennzeichnet, daß der Leseverstärker ferner eine Konstantstromschaltung umfaßt, die aus einem MIS-Transistor (Q3) besteht, der zwischen einem gemeinsamen Anschluß und einem Anschluß (Vss) einer Energiequelle verbunden ist;

- die genannten MIS-Transistoren (Q51, Q52 ... Q5x; Q71, Q72, ... Q7x), die ein decodiertes Adreßsignal ($S_1$, $\overline{S}_1$; $S_2$, $\overline{S}_2$; ... $S_x$, $\overline{S}_x$) empfangen, ihre Sourcen mit dem genannten Gemeinsamen Anschluß verbunden haben;

- eine der genannten Lastschaltungen (Q1) eine direkte Gate-Drain-Verbindung hat, und

- die Gates der Last-MIS-Transistoren (Q1, Q2) und das Gate des MIS-Transistors (Q3) der genannten konstanten Stromquelle gemeinsam verbunden sind.

2. Leseverstärker nach Anspruch 1, dadurch gekennzeichnet, daß die genannten anderen entsprechenden MIS-Transistoren (Q41, Q42, ... Q4x; Q61, Q62, ... Q6x) von jeder der genannten Schaltungseinheiten mit Bitleitungen einer Speichervorrichtung verbunden sind.

3. Leseverstärker nach Anspruch 1, dadurch gekennzeichnet, daß die genannten anderen entsprechenden MIS-Transistoren (Q41, Q42, ... Q4x; Q61, Q62, ... Q6x) mit den Datenbussen einer Speichervorrichtung verbunden sind.

# Fig. 1

# Fig. 2

WL

Qa    MC    Qb

BL    $\overline{BL}$

CTG    CTG

DB    $\overline{DB}$

# Fig. 3

Vcc

$Q_1$    $Q_2$

IN    OUT    $\overline{IN}$

$Q_{4x}$    $Q_{42}$    $Q_{41}$    $Q_{61}$    $Q_{62}$    $Q_{6x}$

$Q_{5x}$    $Q_{52}$    $Q_{51}$    $Q_{71}$    $Q_{72}$    $Q_{7x}$

$Q_3$

$A_x$    $A_2$    $A_1$    Vss    $A_1$    $A_2$    $A_x$

$S_x$    $S_2$    $S_1$    $\overline{S_1}$    $\overline{S_2}$    $\overline{S_x}$